Europäisches Patentamt

European Patent Office

Office européen des brevets

(19)

(11) EP 0 677 220 B1

(12) **FASCICULE DE BREVET EUROPEEN**

(45) Date de publication et mention
de la délivrance du brevet:
**27.08.1997 Bulletin 1997/35**

(21) Numéro de dépôt: **94903928.3**

(22) Date de dépôt: **29.12.1993**

(51) Int Cl.6: **H03F 3/45**

(86) Numéro de dépôt international:
**PCT/FR93/01316**

**WO 94/16494 (21.07.1994 Gazette 1994/17)**

(54) **AMPLIFICATEUR A DISTORSION STABLE POUR SIGNAUX AUDIO**

VERSTÄRKER MIT STABILER VERZERRUNG FÜR TONSIGNALE

STABLE DISTORTION AMPLIFIER FOR AUDIO SIGNALS

(84) Etats contractants désignés:
**DE GB IT**

(30) Priorité: **30.12.1992 FR 9215943**

(43) Date de publication de la demande:
**18.10.1995 Bulletin 1995/42**

(73) Titulaire: **PERROT, Gérard**
**F-92120 Montrouge (FR)**

(72) Inventeur: **PERROT, Gérard**
**F-92120 Montrouge (FR)**

(74) Mandataire: **Lepercque, Jean et al**
**Cabinet Claude Rodhain SA**
**3, rue Moncey**
**75009 Paris (FR)**

(56) Documents cités:
**WO-A-89/03612**

- **JOURNAL OF THE AUDIO ENGINEERING SOCIETY vol. 35, no. 11 , Novembre 1987 , NEW YORK US pages 907 - 915 D.R.G. SELF 'ULTRA-LOW-NOISE AMPLIFIERS AND GRANULARITY DISTORTION'**
- **PATENT ABSTRACTS OF JAPAN vol. 10, no. 201 (E-419)(2257) 15 Juillet 1986 & JP,A,61 043 005 (ROHM CO LTD) 1 Mars 1986**

**Description**

La présente invention s'applique dans le domaine de l'électronique pour signaux audio. Elle concerne un circuit analogique de traitement ou d'amplification des signaux électriques audio.

Les circuits audio doivent être linéaires, c'est-à-dire générer le moins possible de distorsion. Ce terme recouvre les déformations que le circuit fait subir au signal et qui sont liées à ce signal, par opposition au bruit ou aux signaux parasites qui sont décorrélés du signal.

La mesure de la distorsion produite par un circuit se fait traditionnellement en utilisant des signaux d'amplitude constante et consiste à mesurer le rapport entre l'énergie des signaux générés par la distorsion et l'énergie du signal de test. Cette méthode de mesure ne tient pas compte de deux faits :

- d'une part, la perception par le système auditif des signaux générés par la distorsion ne dépend pas que de leur énergie,
- d'autre part, l'utilisation de signaux de test de niveau stable ne définit pas complètement le comportement des circuits testés : ainsi les variations fréquentes de niveau des signaux habituellement amplifiés par les circuits audio (signaux d'origine musicale) peuvent générer, surtout dans les amplificateurs à transistor, des signaux parasites de très basse fréquence liés à l'amplitude du signal qui, s'ils restent inaudibles et s'ils sont généralement éliminés par les circuits eux-mêmes, peuvent moduler les distorsions, les rendant ainsi plus audibles.

Par exemple, dans le cas d'un circuit générant une distorsion composée de distorsion d'ordre 2 avec une amplitude de 0,5 % et de distorsion d'ordre 3 avec une amplitude de 0,25 % ( donc très linéaire ), la superposition d'un signal perturbateur très basse fréquence ( quelques Hertz), va conduire à une modulation de la distorsion du signal utile, à la fréquence du signal perturbateur. Ce phénomène reste en général négligeable mais, si l'amplitude du signal perturbateur est importante, il devient significatif : dans le cas de notre exemple une amplitude du signal perturbateur 10 fois supérieure au signal utile conduit à une modulation de la distorsion d'ordre 2 d'environ 6 dB, la rendant ainsi beaucoup plus perceptible par le système auditif ( phénomène dit d'émergence en psycho-acoustique ).

Les phénomènes générateurs de tels signaux perturbateurs très basse fréquence peuvent être :

- les modifications de tension base-émetteur des transistors résultant des variations de température de leurs jonctions liées aux variations de la puissance dissipée dans ces transistors en fonction de l'amplitude du signal,
- les variations des tensions d'alimentation dont les filtres sont généralement calculés pour filtrer les fréquences des signaux utiles, alors que la consommation peut varier au rythme plus lent des variations de l'amplitude du signal, surtout si tous les circuits ne travaillent pas en classe A.

Les circuits audio à transistor utilisent habituellement de forts taux de contre-réaction pour être les plus linéaires possibles, mais ces taux de contre-réaction élevés conduisent à des gains en boucle ouverte importants y compris pour les signaux continus. Le point de repos en sortie est donc soumis à des dérives importantes en boucle ouverte. La contre-réaction globale a donc deux rôles : réduire les non-linéarités et stabiliser le point de repos en sortie. Mais ce double rôle conduit, ainsi qu'il sera démontré par la suite, à amplifier très fortement des signaux perturbateurs très basse fréquence ( qui correspondent aux dérives du point de repos en sortie ) par rapport au signal utile à l'entrée de l'amplificateur, générant une intermodulation entre le signal utile et les dérives du continu en un point critique pour la distorsion. La présente invention permet de réaliser des circuits à transistor ( ou à transistor et tube ) utilisant de forts taux de contre-réaction tout en évitant ces phénomènes de modulation des distorsions. Pour cela, les circuits réalisés selon l'invention séparent l'action de linéarisation de la contre-réaction, de la stabilisation du point de repos en sortie ; ils filtrent les signaux réinjectés à l'entrée par la boucle de contre-réaction en éliminant en amont de la boucle de contre-réaction les signaux perturbateurs générés dans l'amplificateur et en assurant la stabilisation du point de repos en sortie, et ils stabilisent le fonctionnement de l'étage d'entrée. L'influence des tensions de décalage ou offset et des signaux très basse fréquence ( quelques Hertz ) est ainsi notablement diminuée. Des variantes préférées permettent en outre d'accroître significativement la linéarité du circuit, l'idée de base en étant l'identification du fait que, ainsi qu'il sera démontré par la suite, la linéarité intrinsèque du comparateur de l'étage d'entrée est importante pour obtenir une compensation de la distorsion par action de la contre-réaction, ce qui fait qu'une stabilisation et à fortiori une réduction de la distorsion d'un amplificateur contre-réactionné impliquent pour l'étage d'entrée la maîtrise des signaux d'entrée, de son point de polarisation, de la stabilité de sa fonction de transfert et de la linéarité de sa fonction de transfert.

La présente invention concerne ainsi un amplificateur à distorsion stabilisée pour signaux audio du type comportant une contre-réaction globale et pouvant en outre selon des variantes présenter une distorsion plus faible que les montages de l'art antérieur.

L'invention concerne tout d'abord un amplificateur à transistors pour signaux audio comportant un premier et un deuxième étage présentant une boucle de contre-réaction globale entre la sortie du deuxième étage qui constitue la sortie de l'amplificateur et l'entrée du premier étage, le deuxième étage présentant une boucle de contre-réaction locale entre sa sortie et son entrée, et le premier étage ne comportant pas de contre-réaction locale entre sa sortie et son entrée, la boucle de contreréaction globale et la boucle de contre-réaction locale présentant, respectivement, un premier et un deuxième éléments comparateurs, caractérisé en ce que l'amplificateur comporte un moyen permettant d'empêcher que la tension de décalage présente en sortie du premier étage ne soit réinjecté dans le premier comparateur d'entrée par contre-réaction et en ce que le deuxième étage est contre-réactionné au moins en continu de telle sorte que les signaux perturbateurs basse fréquence générés dans le second étage soient réduits par la contre-réaction du second étage ce qui stabilise son point de fonctionnement, de manière à stabiliser le point de point de polarisation du premier comparateur. Un tel montage évite en outre de mettre en oeuvre un transformateur en sortie du deuxième étage.

Selon une variante avantageuse, l'amplificateur est caractérisé en ce que le premier et/ou le deuxième élément comparateur est tel qu'il présente au moins un transistor critique susceptible de produire des variations de sa fonction de transfert en fonction de l'amplitude des signaux et en ce que ledit transistor est agencé pour présenter une tension collecteur-émetteur $V_{CE}$ faible et/ou constante avec un courant sensiblement constant dans son trajet de courant principal de manière à produire une dissipation thermique stable et/ou faible dans ledit transistor critique. Ceci permet par exemple que le transistor d'entrée du premier étage ait sa puissance dissipée réduite et/ou stabilisée par réduction de sa tension émetteur-collecteur (à environ 1V) et/ou par stabilisation de son courant collecteur et de sa tension émetteur-collecteur . La réduction et/ou la stabilisation de la puissance dissipée dans ce transistor et éventuellement dans d'autres transistors du comparateur du premier étage fait que ce comparateur présente une fonction de transfert qui ne varie pas en fonction de l'amplitude des signaux traités. Il en va de même pour le deuxième étage, mais celui-ci est de ce point de vue beaucoup moins critique ainsi qu'il sera démontré dans la suite de la description. L'amplificateur peut être alors caractérisé en ce que lesdits transistors critiques à dissipation stable ou faible, et faisant partie d'un comparateur, sont isolés thermiquement des variations de température induites par d'autres composants, ou stabilisés thermiquement par une stabilisation qui leur est extérieure.

Selon une autre variante de l'amplificateur, le premier étage utilise une charge de forte impédance, par exemple une charge active, de manière à lui conférer un gain élevé et le second étage comporte une contre-réaction qui traite également les signaux dans la bande audio.

Selon une variante avantageuse, l'amplificateur est caractérisé en ce que le premier et/ou le deuxième étage utilise un comparateur de grande linéarité présentant deux sous-étages en série pour former une contre-réaction locale.

Selon une autre variante avantageuse, l'amplificateur est caractérisé en ce que le premier comparateur présente une combinaison d'éléments actifs dont les non-linéarités se compensent.

Selon un mode de réalisation particulièrement avantageux, l'amplificateur est réalisé en ce que le premier étage comprend deux modules dont chacun présente un premier transistor d'un premier type de conductivité dont la base constitue une borne d'entrée pour un signal d'entrée, les émetteurs du premier transistor de chaque module étant couplés pour former un étage différentiel, et un moyen pour maintenir un courant sensiblement constant dans le trajet collecteur-émetteur du premier transistor, ledit moyen comportant un circuit de contre-réaction présentant un trajet de courant principal entre une borne active constituant une sortie du premier étage et l'émetteur du premier transistor, en ce que ledit moyen est constitué par une première source de courant connectée au collecteur du premier transistor et en ce que le circuit de contre-réaction est agencé de manière telle que la valeur dudit courant principal est fonction de la différence entre la tension d'une source de tension de référence et le potentiel du collecteur du premier transistor, le gain du circuit de contre-réaction étant choisi de manière telle que le potentiel du collecteur du premier transistor soit sensiblement constant.

Selon un mode de réalisation préféré de cette variante, l'amplificateur est caractérisé en ce que le trajet de courant principal du circuit de contre-réaction comporte un deuxième transistor d'un deuxième type de conductivité opposé au premier type de conductivité, dont le collecteur est connecté à l'émetteur du premier transistor, dont la base est connectée au collecteur du premier transistor, et dont l'émetteur est connecté à l'émetteur d'un troisième transistor d'un premier type de conductivité, dont la base est connectée à ladite source de tension de référence, et dont le collecteur constitue ladite sortie du premier étage.

La boucle de contre-réaction du second étage stabilise le point de repos en sortie. Pour éliminer les composantes continues issues du premier étage, le deuxième étage peut ainsi comporter un condensateur disposé en série à l'entrée du deuxième étage et, dans ce cas, la contre-réaction du second étage peut être indépendante de la fréquence, ou bien le deuxième étage peut se comporter comme un filtre grâce à la sélectivité de sa boucle de contre-réaction locale.

Selon un mode de réalisation préféré, l'amplificateur qui présente une boucle de contre-réaction par pont diviseur résistif entre la sortie du second étage et une entrée du premier étage est tel que le premier étage comporte un étage différentiel d'entrée et le deuxième étage, pouvant être du type différentiel, présente une boucle de contre-réaction locale comportant un circuit intégrateur dont l'entrée est connectée à la sortie du deuxième étage et dont la sortie est connectée à une première entrée d'un étage différentiel de contre-réaction, les sorties de l'étage différentiel de contre-réaction ayant une deuxième entrée à potentiel constant, les sorties de l'étage différentiel de contre-réaction étant couplées aux entrées respectives du deuxième étage, de manière à réaliser un filtre actif qui élimine d'une part les signaux continus ou basse fréquence issus du premier étage et d'autre part, ceux générés dans le deuxième étage, ce qui stabilise le point de fonctionnement.

D'autres caractéristiques et avantages de l'invention apparaîtront mieux à la lecture de la description qui va suivre, donnée à titre d'exemple non limitatif, en liaison avec les dessins qui représentent :

- la figure 1, un amplificateur à deux étages de l'art antérieur,
- la figure 2, un amplificateur présentant une contre-réaction classique,
- la figure 3, deux étages amplificateurs en série,
- la figure 4, un schéma d'un amplificateur à deux étages selon l'invention,
- la figure 5, un mode de réalisation préféré de l'amplificateur selon la figure 4,
- la figure 6, un autre mode de réalisation préféré de l'amplificateur selon la figure 4,
- la figure 7, un autre mode de réalisation préféré de l'amplificateur selon la figure 4,
- la figure 8, un mode de réalisation préféré du premier étage de l'amplificateur selon la figure 4,
- la figure 9, un autre mode de réalisation du premier étage de l'amplificateur selon la figure 4,
- la figure 10, un mode de réalisation préféré de l'amplificateur selon la figure 5.

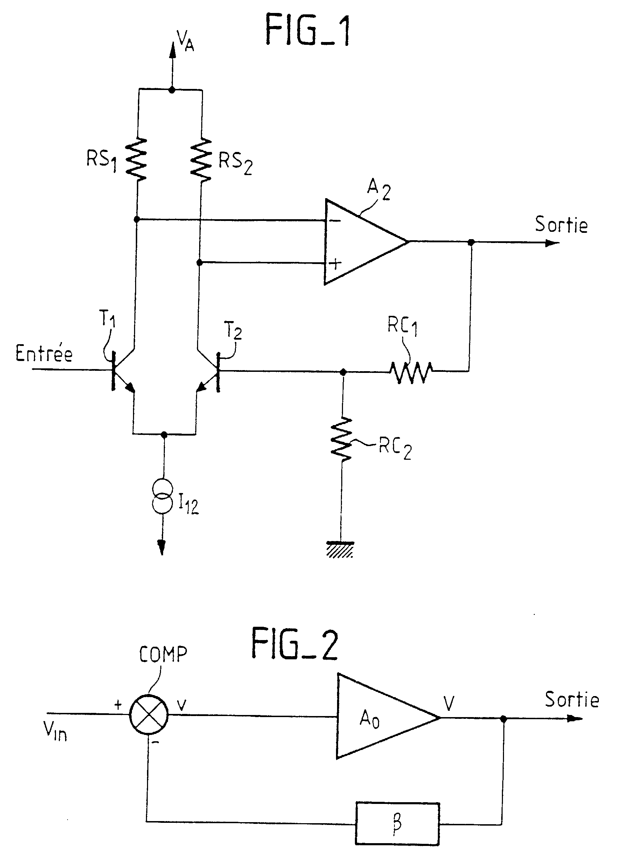

Les circuits amplificateurs audio contre-réactionnés de type connu ont souvent une structure voisine de celle de la figure n°1 : ils utilisent un étage d'entrée différentiel à deux transistors $T_1$ et $T_2$ couplés par les émetteurs à une source de courant $I_{12}$ et un amplificateur $A_2$ dont l'entrée inverseuse est couplée au collecteur du transistor $T_1$ ( relié à une source de courant d'alimentation $V_A$ à travers une résistance $R_{S1}$ ) et/ou dont l'entrée non-inverseuse est couplée au collecteur du transistor $T_2$ ( relié à une source de courant d'alimentation $V_A$ à travers une résistance $R_{S2}$). La contre-réaction est obtenue en rétro-couplant la sortie de l'amplificateur $A_2$ à la base du transistor $T_2$ à travers un pont diviseur résistif ( $RC_1$, $RC_2$ ). La linéarité d'un tel circuit résulte principalement de l'action de la contre-réaction globale qui réduit les non-linéarités.

La théorie qui explique l'action de la contre-réaction est souvent formulée ainsi :

Soit un amplificateur $A_o$ dont la tension d'entrée est notée v, et la tension de sortie V. Une fonction de transfert définit la relation entre ces deux grandeurs :

$$V = f(v)$$

Cette fonction de transfert peut être développée suivant Taylor et s'écrire :

$$V = f(v) = a_0 + a_1 v + a_2 v^2 + a_3 v^3 + a_4 v^4 + a_5 v^5 + .......$$

La distorsion est générée par la partie non-linéaire D de cette fonction :

$$D(v) = a_2 v^2 + a_3 v^3 + a_4 v^4 + a_5 v^5 + ....... \qquad (1)$$

On peut donc écrire :

$$V = A_o (v - v_o) + D(v) \qquad (2)$$

avec

$A_o$ = le gain de l'amplificateur

$v_o = v'_o + \dfrac{D(v'_o)}{A_o}$, avec $v'_o$ = la tension de décalage ( ou "offset" ) d'entrée = la tension qu'il faut appliquer à l'entrée pour obtenir une tension nulle en sortie. En général $v_o \approx v'_o$ et dans la suite du texte on assimilera $v_o$ à la tension de décalage.

$D(v)$ = la partie non-linéaire de la fonction de transfert qui génère la distorsion.

L'application de la contre-réaction conduit à réinjecter le signal d'entrée à travers un réseau de gain β ( voir la figure n°2 ). Un comparateur COMP effectue la comparaison entre le signal de sortie du réseau et la tension d'entrée du montage vin .

La tension d'entrée de l'amplificateur $A_o$ devient :

$$v = v_{in} - \beta V \qquad (3)$$

En éliminant v entre les équations (2) et (3) on trouve la fonction de transfert de l'amplificateur rebouclé par la contre-réaction :

$$V = \frac{A_o}{1 + A_o\beta}(v_{in} - v_o) + \frac{D(v)}{1 + A_o\beta} \qquad (4)$$

qui peut aussi s'écrire :

$$V = \frac{1}{\beta}\frac{1}{1 + \frac{1}{A_o\beta}}(v_{in} - v_o) + \frac{D(v)}{1 + A_o\beta} \qquad (5)$$

Si le gain de l'amplificateur est élevé, on a : $A_o\beta \gg 1$ ; la fonction de transfert (5) devient :

$$V \approx \frac{1}{\beta}(v_{in} - v_o) + \frac{D(v)}{A_o\beta} \qquad (6)$$

La comparaison des fonctions de transfert de l'amplificateur en boucle ouverte (2) et de l'amplificateur en boucle fermée (6) montre les effets de la contre-réaction :

- La contre-réaction impose au montage un gain égal à l'inverse du gain du réseau de contre-réaction ( à condition que le gain initial du montage soit suffisamment élevé ).
- La tension de décalage d'entrée n'est pas affectée par la contre-réaction.
- La distorsion est divisée par le gain de boucle : $A_o\beta$

En conséquence, on cherche habituellement à augmenter le gain en boucle ouverte des circuits amplificateurs pour accroître le gain de boucle et ainsi améliorer la linéarité en boucle fermée. Mais dans le domaine audio, l'application de cette stratégie ne semble pas donner des résultats sonores satisfaisants lorsqu'on recherche une qualité extrême. Un tel insuccès est expliqué par l'analyse plus poussée des phénomènes de distorsion dans les étages d'amplification, qui suit :

Si on pose :

$$d(v) = \frac{D(v)}{A_o} \qquad (7)$$

On peut écrire la fonction de transfert de l'amplificateur en boucle ouverte sous la forme :

$$V = A_o(v - v_o + d(v)) \qquad (2')$$

La fonction de transfert de l'amplificateur en boucle fermée devient ainsi :

$$V \approx \frac{1}{\beta}(v_{in} - V_o + d(v)) \qquad (6')$$

La comparaison des nouvelles expressions des fonctions de transfert de l'amplificateur en boucle ouverte (2') et de l'amplificateur en boucle fermée (6') montre mieux les effets de la contre-réaction sur la non-linéarité : d(v) est une distorsion intrinsèque définie à l'entrée, comme la tension de décalage est définie en entrée. Comme la tension de décalage, la distorsion intrinsèque est amplifiée avec le gain imposé par la contre-réaction. On peut considérer que l'amplificateur $A_o$ ( figure 2 ) amplifie linéairement une tension qui est affectée d'une distorsion propre à la fonction de comparaison entre $v_{in}$ et $\beta V$ et que cette distorsion n'est pas compensée par la boucle de contre-réaction : comme la tension de décalage, cette distorsion intrinsèque est assimilable à une erreur de mesure systématique.

Dans un amplificateur contre-réactionné, la distorsion présente en sortie est donc la distorsion intrinsèque multipliée par le gain imposé par la contre-réaction. Selon l'invention, pour maîtriser la distorsion, on met en oeuvre une stratégie d'utilisation de la contre-réaction plus élaborée que la simple recherche d'un gain élevé en boucle ouverte. Lors de la conception d'un montage amplificateur, le gain de l'amplificateur en boucle fermé ($1/\beta$) est très souvent défini à l'avance ; ainsi, pour réduire la distorsion, le paramètre à surveiller en boucle ouverte n'est pas le gain $A_o$ qu'on cherche habituellement à augmenter par tous les moyens, mais la distorsion intrinsèque qu'il faut chercher à minimiser.

La distorsion intrinsèque est définie par :

$$d(v) = \frac{D(v)}{A_o} \tag{7}$$

Cette formule montre bien que l'augmentation du gain $A_o$ en boucle ouverte ne conduit à un gain de linéarité en boucle fermée que si cette augmentation ne se traduit pas par une augmentation égale ou supérieure de la distorsion en boucle ouverte. Pour maîtriser la distorsion, il faut maîtriser D(v). Or D(v) est de la forme :

$$D(v) = a_2 v^2 + a_3 v^3 + a_4 v^4 + a_5 v^5 + ...... \tag{1}$$

$$D(v) = v^2(a_2 + a_3 v + a_4 v^2 + a_5 v^3 + ......) \tag{1'}$$

Selon cette formule, D(v) croît en première approximation comme le carré de v ( la tension d'entrée en boucle ouverte ) ; il faut donc que cette tension soit la plus faible possible.

En remplaçant V défini par (4) dans (3) on peut exprimer v en fonction de $v_{in}$ :

$$v = \frac{v_{in}}{1 + \beta A_o} + \frac{\beta A_o v_o}{1 + \beta A_o} - \frac{\beta D(v)}{1 + \beta A_o} \tag{8}$$

en tenant compte de $A_o \beta \gg 1$ et de (7) on obtient :

$$v \approx \frac{v_{in}}{1 + \beta A_o} + v_o + d(v) \tag{9}$$

Mais cette analyse n'est pas complète : la charge de l'amplificateur influe aussi sur v. Si on note $\Delta V$ la chute de tension de sortie provoquée en boucle ouverte par la fourniture de courant à la charge, la tension de sortie est :

$$V_{out} = V - \Delta V$$

$$V_{out} = A_o(v - v_o + d(v)) - \Delta V$$

En posant :

$$\delta V = \frac{\Delta V}{A_o}$$

on obtient :

$$V_{out} = A_o \ (v - v_o + d(v) - \delta V) \tag{2'''}$$

L'action de la contre-réaction s'écrit :

$$v = v_{in} - \beta \ V_{out} \tag{3'}$$

La fonction de transfert de l'amplificateur en boucle fermée devient :

$$V_{out} \approx \frac{1}{\beta} \Big( v_{in} - v_o + d(v) - \delta V \Big) \tag{6''}$$

La tension d'entrée est alors :

$$v \approx \frac{v_{in}}{\beta A_o} + v_o + d(v) - \delta V \tag{9'}$$

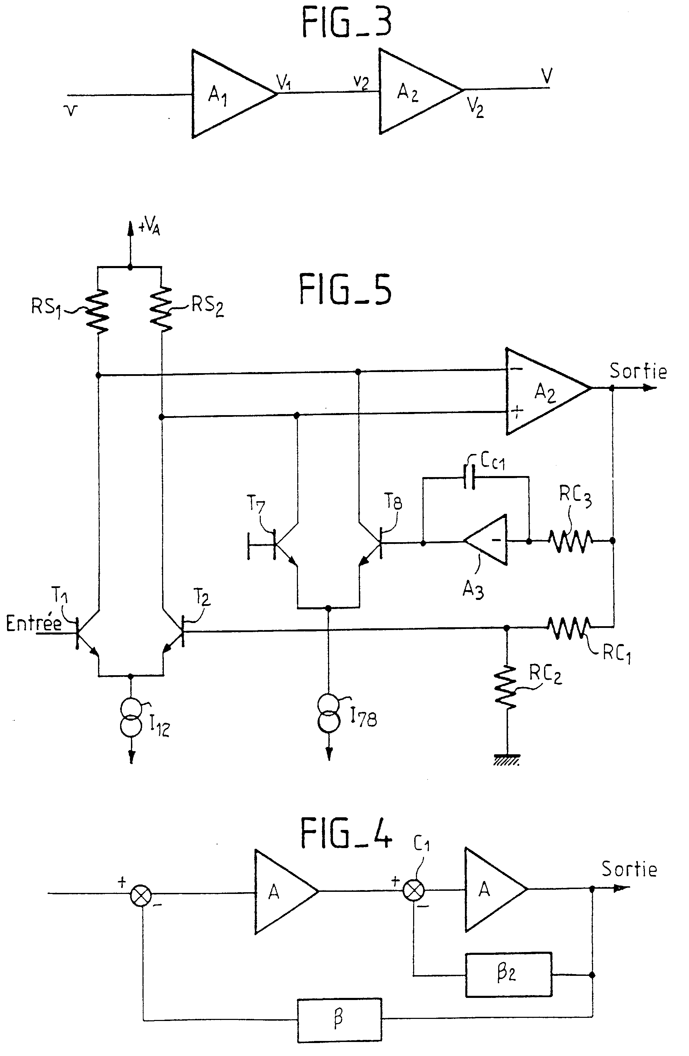

L'analyse du cas particulier de deux amplificateurs en série ( figure 3 ) permet de décomposer la distorsion intrinsèque, de comprendre les faiblesses de l'art antérieur et de saisir la stratégie de lutte contre la distorsion objet de la présente invention.

Soient deux amplificateurs en série $A_1$ et $A_2$ de gain respectivement $A_{01}$ et $A_{02}$ et ayant pour fonction de transfert $f_1$ et $f_2$.

En utilisant les deux fonctions de transfert exprimées selon (2"), on a :

$$V_1 = f_1(v_1) = A_{o1}(v_1 - v_{o1} + d_1(v_1)) \tag{10}$$

$$V_2 = f_2(v_2) = A_{o2}(v_2 - v_{o2} + d_2(v_2)) \tag{11}$$

et en tenant compte de $v = v_1$, de $V_2 = V$ et de $V_1 = v_2$, on obtient la fonction de transfert globale :

$$V = A_{o1}A_{o2}\left( v - v_{o1} - \frac{v_{o2}}{A_{o1}} + d_1(v) + \frac{d_2(v_2)}{A_{o1}} \right) \tag{12}$$

Si nous analysons cette formule nous voyons que :

- le gain global est le produit des gains des deux amplificateurs :

$$A_o = A_{o1}A_{o2} \tag{13}$$

- la tension de décalage est donnée par :

$$v_o = v_{o1} + \frac{v_{o2}}{A_{o1}} \tag{14}$$

C'est principalement celle du premier étage, puisque la tension de décalage du second étage est divisée par le gain du premier étage

- la distorsion intrinsèque est égale à la distorsion intrinsèque du premier étage plus la distorsion intrinsèque du second étage divisée par le gain du premier étage :

$$d(v) = d_1(v) + \frac{d_2(v_2)}{A_{o1}} \tag{15}.$$

L'application d'une contre-réaction globale conduit, en utilisant (6"), à :

$$V \approx \frac{1}{\beta}\left(v_{in} - v_{o1} - \frac{v_o 2}{A_{o1}} + d_1(v) + \frac{d_2(v_2)}{A_{o1}} - \delta V\right) \tag{16}$$

Ce qui conduit à une distorsion qui vaut :

$$D = \frac{1}{\beta}\left(d_1(v) + \frac{d_2(v_2)}{A_{o1}}\right) \tag{17}$$

avec une tension d'entrée v qui, selon (9'), vaut :

$$v \approx \frac{v_{in}}{\beta A_o} + v_o + d_1(v) + \frac{d_2(v_2)}{A_{o1}} - \delta V \tag{18}$$

L'analyse de ces résultats permet de comprendre comment on peut compenser la distorsion par une action optimale de la contre-réaction : la distorsion est donnée par

$$D = \frac{1}{\beta}\left(d_1(v) + \frac{d_2(v_2)}{A_{o1}}\right) \tag{17}$$

Pour réduire la distorsion, on peut agir sur chaque terme de cette expression :

- le terme $1/\beta$ est souvent défini à l'avance et peut difficilement être réduit,
- le terme $d_1(v)$ dépend de la linéarité du premier étage et de l'amplitude de v ; il est donc préférable que le premier étage soit linéaire et que l'amplitude de v soit faible,
- le terme $d_2(v_2)/A_{o1}$ dépend de la linéarité du second étage, de l'amplitude de $v_2$ et du gain du premier étage ; il est donc préférable que le second étage soit linéaire et que le premier étage ait un gain élevé. L'amplitude de $v_2$ est liée à l'amplitude du signal de sortie et donc difficilement réductible.

Si le gain du premier étage est important, c'est donc la linéarité du premier étage et l'amplitude de v qui sont critiques pour la distorsion. Or v vaut :

$$v \approx \frac{v_{in}}{\beta A_o} + v_o + d_1(v) + \frac{d_2(v_2)}{A_{o1}} - \delta V \tag{18}$$

Pour réduire la distorsion, on peut agir sur chaque terme de l'expression de v:

- le terme $v_{in}/\beta A_0$ dépend du signal d'entrée et du gain de boucle ; le signal d'entrée est donné ; il est donc préférable que le gain de boucle soit élevé, et c'est une règle bien connue,
- le terme $v_o$ est lié aux tensions de décalage et est généralement considéré comme fixe,
- nous avons déjà considéré les termes liés à la distorsion,
- le terme $\delta V$ ($\Delta V/A_o$) dépend du courant fourni à la charge qu'on ne maîtrise pas, de l'impédance de sortie en boucle ouverte qu'il est préférable de réduire et du gain en boucle ouverte qui doit être élevé.

On peut résumer cette analyse en disant que dans une chaîne d'amplification contre-réactionnée, le premier étage (c'est-à-dire le premier circuit actif rencontré par le signal, celui qui fait office de comparateur de la boucle de contre-réaction ) est essentiel pour la linéarité, surtout si son gain est important, puisque sa distorsion intrinsèque n'est pas réduite par l'action de la contre-réaction. La distorsion des autres étages conduit à accroître un terme du signal d'entrée du premier étage et donc sa distorsion intrinsèque, mais leur distorsion est masquée par le gain du premier étage, alors que le gain de ces étages permet de réduire un autre terme du signal d'entrée.

Ceci nous permet de définir les règles de conception pour minimiser la distorsion dans un circuit contre-réactionné comportant plusieurs étages qu'on peut diviser entre le premier étage $A_1$ et le ou les autre(s) étage(s) (regroupés en un second étage) $A_2$ :

Il faut d'abord que le premier étage A1 soit :

- de gain élevé pour masquer les distorsions des étages suivants,
- très linéaire puisque sa distorsion intrinsèque n'est pas réduite par la contre-réaction et que les actions de la contre-réaction pour réduire les non-linéarités des étages suivants et la chute de tension due à la charge, accroissent son signal d'entrée.

Il est préférable ensuite que le second étage $A_2$ soit :

- de gain élevé pour contribuer à réduire le premier terme de l'expression de v (18)
- linéaire pour limiter sa contribution au non-linéarités du montage, malgré le masquage de sa distorsion par le gain du premier étage $A_1$, et qu'ainsi la compensation de ses distorsions par la contre-réaction ne provoque des distorsions dans le premier étage $A_1$.

Il est préférable enfin que la résistance de sortie soit faible pour éviter que la réduction de $\Delta V$ par la contre-réaction ne provoque des distorsions dans le premier étage A1.

On notera que, selon la théorie développée ci-dessus, une contre-réaction locale dans le premier ou le second étage ne conduit qu'à réduire le gain de l'étage considéré sans modifier ni sa tension de décalage, ni sa distorsion intrinsèque et que l'impact d'une contre-réaction locale sur la distorsion semble négatif :

- pour le premier étage, une contre-réaction locale réduit le gain de cet étage et donc le gain global, accroissant ainsi le premier terme de l'expression (18), et en outre, démasque les distorsion du second étage,
- pour le second étage, une contre-réaction locale réduit le gain de cet étage et donc le gain global, accroissant ainsi le premier terme de l'expression (18).

La théorie développée ci-dessus recommande donc pour réduire la distorsion, d'éviter les contre-réactions locales et de faire bénéficier tous les étages de tout le gain qu'on veut reboucler. Mais cette recommandation ne tient pas compte des restrictions imposées par les problèmes de stabilité de boucle qui limitent dans la pratique le gain de boucle global et donc le gain global en boucle ouverte. Une contre-réaction locale peut donc aider à réduire les distorsions si elle permet d'augmenter le gain contre-réactionné en contournant les problèmes de stabilité de boucle.

D'autre part, pour stabiliser la distorsion, il faut, dans les différentes formules, maîtriser les termes correspondant aux tensions continues ( les tensions de décalage ) ; il est couramment admis que ces termes ne font intervenir que des tensions continues sans relation avec la distorsion. En réalité, les tensions continues sont importantes parce qu'elles modifient les points de polarisation des éléments actifs. En particulier, la relation (18) montre que la tension de décalage globale d'entrée ("offset") détermine principalement la tension continue d'entrée et donc modifie le point de polarisation de l'étage d'entrée qui est déterminant pour la distorsion : selon le point de fonctionnement sur la courbe de la fonction de transfert du premier étage, la nature et l'amplitude de ses distorsions peuvent changer.

Un point important pour la stabilité de la distorsion est donc la stabilité de la tension de décalage ; en effet il est couramment admis que les fonctions de transfert sont stables, alors qu'elles dépendent des caractéristiques des composants et que ceux-ci ( en particulier les transistors ) voient leurs caractéristiques ( principalement leurs tensions base-émetteur ) varier avec la température. Les variations de température sont liées aux conditions thermiques ambiantes et à la dissipation interne fonction du signal ( distorsion thermique ). Parmi les causes de variation de la tension de décalage, il faut noter également les évolutions des tensions d'alimentation.

Dans le cas des signaux audio, la non-stabilité de la distorsion en renforce la perception et donne donc des effets très désagréables pour les oreilles.

Cela nous conduit à compléter les règles de conception d'amplificateurs audio : pour stabiliser la distorsion, les tensions de décalages produites par le montage ne doivent pas être réinjectées à l'entrée du premier étage par la boucle de contre-réaction. Il est en outre préférable que le premier étage ( le comparateur de la boucle ) soit très stable et dépourvu de distorsion thermique.

On notera que la stratégie traditionnelle de lutte contre la distorsion, à savoir un accroissement du gain en boucle ouverte, conduit à obtenir en entrée du comparateur de l'amplificateur ( en un point où la contre-réaction n'a pas d'effets sur la distorsion ) le signal utile ( $v_{in}$ ) divisé par le gain de boucle, c'est-à-dire très petit devant l'offset ; ainsi une modulation de la tension de décalage aura sur la distorsion les effets pernicieux décrits plus haut.

On notera qu'une contre-réaction locale dans le second étage ne change pas l'offset global ( voir (14) ) ni les problèmes de modulations de distorsion, et qu'une contre-réaction locale dans le premier étage dégrade l'offset global en démasquant celui du second étage et peut aggraver les problèmes de modulations de distorsion.

Analysons la distorsion du schéma de la figure 1 : dans ce schéma très classique, le premier étage est constitué d'un circuit différentiel à deux transistors $T_1$ et $T_2$. Sa fonction de transfert est de la forme :

$$I_{out} = \frac{I_o}{1 + \exp\left(\frac{Q(v - v_o)}{kT}\right)} \qquad (19)$$

Elle n'est guère linéaire dès que v a une certaine amplitude. En général, les étages suivants sont peu linéaires puisqu'on attend une linéarité globale résultant de leur gain élevé et de l'action de la contre-réaction. Cette action peut donc se traduire, à l'entrée de l'amplificateur, par des signaux d'une amplitude suffisante pour dégrader à l'entrée la distorsion intrinsèque qui sera amplifiée avec le gain du montage.

Il faut minimiser v. Une augmentation de $A_{o2}$, comme la théorie classique pousse beaucoup de concepteurs à le faire avec les limites imposées par la stabilité de la boucle, ne permet que de diminuer le premier terme de l'expression (18) ; si cette augmentation conduit à dégrader la linéarité du second étage, il est possible que, malgré le masquage de la distorsion du second étage $A_2$ par le gain du premier étage $A_1$ ( voir (17) ), la distorsion globale soit augmentée. D'autre part, cette augmentation va accroître les risques de modulation de la distorsion par les variations d'offset.

La distorsion de ce montage est, en effet, sensible aux variations de la tension de décalage d'entrée de tout le montage ( variations des alimentations et des températures de jonction des transistors ) et à la distorsion thermique du premier étage ( $T_1$, $T_2$ ), car le signal utile y est faible devant les dérives du continu ; en outre, habituellement on ne se soucie guère des variations de la tension de décalage du second étage puisqu'on compte sur la contre-réaction globale pour stabiliser son point de fonctionnement. Pour cela, on renforce même parfois la contre-réaction en continu par un condensateur en série avec $R_{c2}$ ou par un montage intégrateur en parallèle avec $R_{c1}$. Cette action ne peut qu'aggraver les problèmes de modulation de distorsion.

L'utilisation d'une contre-réaction locale par résistances d'émetteur $R_1$ et $R_2$ ( respectivement entre l'émetteur de $T_1$ et la source de courant $I_{12}$, et entre l'émetteur de $T_2$ et la source de courant $I_{12}$ ) ne résout pas les problèmes de modulation de distorsion par les dérives de polarisation : le premier étage est plus linéaire mais son gain est plus faible. Sa distorsion thermique n'est pas modifiée puisque la dissipation reste la même. Sa distorsion intrinsèque n'est pas modifiée, donc ses propres non-linéarités ont toujours le même effet et les non-linéarités des autres étages sont moins masquées. En revanche, cette disposition peut simplifier des problèmes de stabilité de la boucle de contre-réaction.

Selon l'invention, en application de la théorie exposée ci-dessus, on cherche :

- à stabiliser la distorsion en évitant que les tensions continues et très basse fréquences ne soient réinjectées par la boucle de contre-réaction globale, tout en stabilisant le point de fonctionnement des circuits qui suivent le premier étage,

- puis à augmenter la stabilité de la distorsion en stabilisant le fonctionnement du comparateur de la boucle ( premier étage ),

- et, enfin, à réduire la distorsion.

Pour cela on combine dans un montage globalement contre-réactionné, un premier étage ( le comparateur de la boucle, de préférence très linéaire et de gain élevé ) qui reste de préférence stable quand l'amplitude des signaux varie, et un second étage dont la stabilité ( et éventuellement la linéarité ) est( sont ) améliorée(s) par une contre-réaction. En outre pour éviter les problèmes liés à l'amplification des tensions continues et très basse fréquence issues du premier étage, on effectue un filtrage passe-haut, soit à l'aide d'un filtre passe-haut introduit entre le premier et le second étage, soit par contre-réaction du deuxième étage.

Le montage selon l'invention est prévu pour amplifier des signaux audio ne présentant pas de composante continue ou très basse fréquence. Dans le cas de la présence dans le signal à traiter d'une composante continue ou de signaux très basse fréquence, l'absence de contre-réaction sur ces signaux conduirait à un niveau élevé pour ces signaux au niveau du premier étage et pourrait ainsi induire, avec les non-linéarités de cet étage, une modulation de la distorsion ; il est donc préférable d'éliminer ces signaux en amont du montage par filtrage pour éviter que ce ne soient eux qui fixent le point de fonctionnement du premier étage.

L'amplificateur objet de la présente invention est composé, dans le cas de la figure 4, de deux étages amplificateurs, rebouclés dans une contre-réaction globale β et dont le second étage voit son fonctionnement en continu stabilisé par une seconde contre-réaction $\beta_2$ qui lui est propre.

La figure 5 montre un exemple d'un tel circuit réalisé sur la base du schéma de la figure 1, dans lequel on a ajouté un second étage d'entrée différentiel à deux transistors $T_7$ et T8 de la même polarité que $T_1$ et $T_2$, couplés par les émetteurs à une source de courant $I_{78}$, le collecteur de $T_7$ étant couplé au collecteur de $T_2$ et le collecteur de $T_8$ étant couplé au collecteur de $T_1$, la base de $T_7$ est reliée à un potentiel fixe pouvant être la masse, la base de $T_8$ est reliée à la sortie de $A_2$ qui est la sortie du montage à travers un circuit intégrateur constitué d'un amplificateur $A_3$ dont l'entrée inverseuse est reliée à la sortie de $A_2$ à travers une résistance $R_{c3}$ et à sa propre sortie à travers une capacité $C_{c1}$, la base de $T_8$ est ainsi reliée à la sortie de $A_3$. Le circuit ajouté réalisant avec $A_2$ un filtre actif qui à la fois élimine les signaux continus et très basse fréquence issus du premier étage et ceux qui pourraient être générés dans $A_2$. Le point de fonctionnement de A2 est ainsi stabilisé.

On notera que si cette réalisation rappelle l'art antérieur dans le cas évoqué ci-dessus où un montage intégrateur dans le réseau de contre-réaction stabilise le point de repos en sortie, la stabilisation est ici obtenue en agissant en un point aval par rapport au comparateur d'entrée que constituent $T_1$ et $T_2$, et donc sans en perturber le fonctionnement, alors que dans l'art antérieur, on perturbe le fonctionnement du premier étage en agissant sur son point de polarisation pour stabiliser le point de repos en sortie.

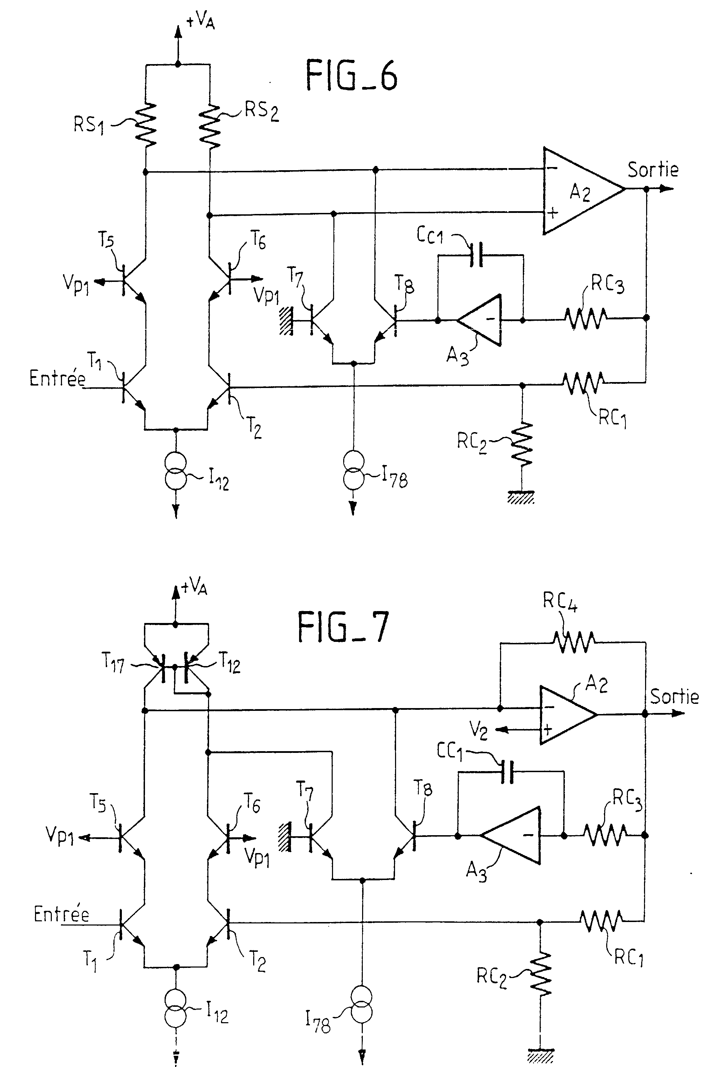

La figure 6 montre un autre exemple d'un tel circuit réalisé sur la base du schéma de la figure 5, dans lequel on a amélioré la stabilité de la distorsion en limitant la dissipation de $T_1$ et $T_2$, en limitant la puissance qui y est dissipée grâce à un double montage cascode : un transistor $T_5$, de même polarité que $T_1$, relie le collecteur de $T_1$ au reste du circuit, son émetteur étant couplé au collecteur de $T_1$, sa base étant reliée à un potentiel $V_{p1}$ tel que la tension émetteur-collecteur de $T_1$ soit faible ( typiquement 0,8 V ) ; un transistor $T_6$ de même polarité que $T_2$, relie le collecteur de $T_2$ au reste du circuit, son émetteur étant couplé au collecteur de $T_2$, sa base étant reliée à un potentiel $V_{p1}$ tel que la tension émetteur-collecteur de $T_2$ soit faible ( typiquement 0,8 V ) On pourrait remplacer $V_{p1}$ par des tensions respectivement asservies à des tensions faiblement supérieures ( typiquement de 0,8 V ) aux potentiels d'émetteur de respectivement $T_1$ et $T_2$.

La réduction des tensions base-émetteur des transistors du comparateur du premier étage à une faible valeur est un moyen simple de réduire leur dissipation et ainsi de rendre leur température et donc leurs caractéristiques électriques indépendantes de l'amplitude des signaux traités.

La figure 7 montre un autre exemple d'un tel circuit réalisé sur la base du schéma de la figure 6, dans lequel on a accru le gain du premier étage par utilisation d'une charge active ( donc de forte impédance ) et contre-réactionné le second étage. Ceci permet d'augmenter le taux de contre-réaction réduisant les non-linéarités du second étage et la chute de tension due à la charge et ainsi de réduire leur contribution à la tension d'entrée du premier étage, sans augmenter le gain en boucle ouverte et donc sans provoquer de problèmes de stabilité de la boucle globale.

Pour cela, les résistances $R_{s1}$ et $R_{s2}$ sont remplacées par deux transistors $T_{11}$ et $T_{12}$ de polarité opposée à $T_1$ et $T_2$, les émetteurs de $T_{11}$ et $T_{12}$ étant reliés au potentiel d'alimentation $V_A$, les bases de $T_{11}$ et $T_{12}$ étant couplées entre elles et au collecteur de $T_{12}$, le collecteur de $T_{11}$ étant couplé aux collecteurs de $T_5$ et $T_8$ et à l'entrée inverseuse de $A_2$, le collecteur de $T_{12}$ étant couplé aux collecteurs de $T_6$ et $T_7$, une résistance de contre-réaction $R_{c4}$ étant branchée entre l'entrée inverseuse de $A_2$ et la sortie de $A_2$, l'entrée non-inverseuse de $A_2$ ( si elle existe ) étant reliée à un potentiel fixe $V_2$.

Il est possible d'améliorer la linéarité des circuits décrits ci-dessus en utilisant comme comparateur de la boucle globale ( le premier étage ) un circuit plus linéaire. Ceci peut être obtenu par le surcroît de gain fourni par quelques éléments actifs et par une contre-réaction locale, ou bien par un circuit dans lequel les non-linéarités intrinsèques aux éléments actifs se compensent, la stabilité de ces circuits étant obtenue en réduisant et/ou stabilisant les dissipations intervenant dans les composants critiques pour la fonction de transfert.

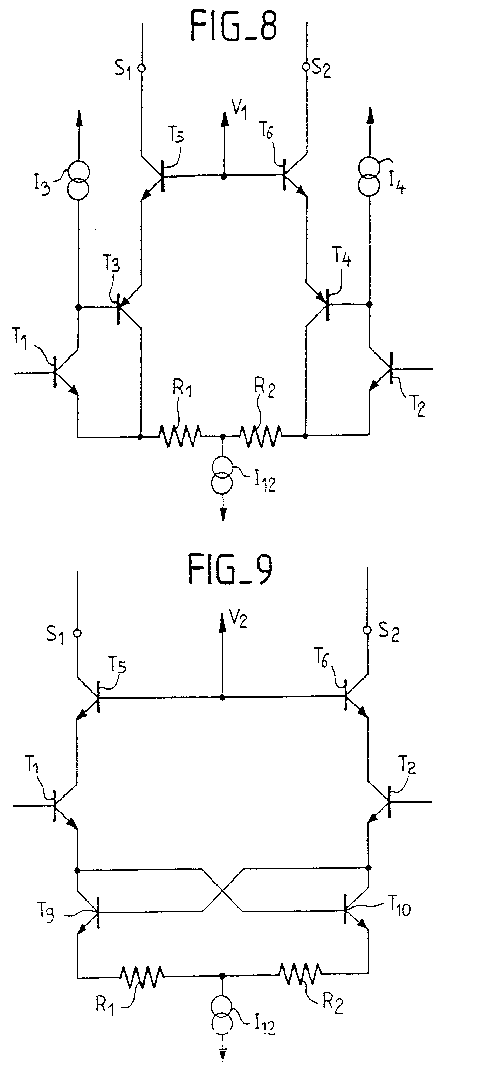

La figure 8 montre un exemple d'un tel circuit dans lequel la linéarité a été obtenue par mise en oeuvre de plusieurs transistors et par deux contre-réactions locales en courant qui stabilisent les courants émetteur et donc les tensions $V_{BE}$ des deux transistors d'entrée. La distorsion thermique y est réduite car les deux transistors d'entrée ont également leurs tensions de collecteur stabilisées à une faible valeur par la tension de référence $V_1$.

La figure 8 propose selon l'invention un montage permettant en outre d'éliminer les problèmes de distorsion thermique mentionnés ci-dessus. Un transistor $T_3$ a sa base connectée au collecteur de $T_1$, et son collecteur à l'émetteur de $T_1$. Un transistor $T_4$ a sa base connectée au collecteur de $T_2$, et son collecteur à l'émetteur de $T_2$. La charge du collecteur des transistors $T_1$ et $T_2$ est constituée par des sources de courant, respectivement $I_3$ et $I_4$. Deux transistors $T_5$ et $T_6$ de même type que les transistors $T_1$ et $T_2$ ont leur base portée à un potentiel de référence $V_1$ et leurs émetteurs connectés à ceux respectivement des transistors $T_3$ et $T_4$. Le collecteur des transistors $T_5$ et $T_6$ constitue les sorties $S_1$ et $S_2$ de l'étage différentiel ( résistances $R_{S1}$ et $R_{S2}$ ). On remarquera également qu'à titre de variante les émetteurs des transistors $T_1$ et $T_2$ peuvent être couplés par une résistance $R_{12}$, et connectés chacun à une source de courant, respectivement $I_1$ et $I_2$ ( non représentées ).

Dans ce montage, le courant de contre-réaction est fixé par la différence entre le potentiel du collecteur des transistors $T_1$ et $T_2$ et la tension de référence $V_1$. En effet, les transistors $T_3$ et $T_5$ d'une part et $T_4$ et $T_6$ d'autre part de type opposé étant couplés par leur émetteurs, le courant traversant leur trajet collecteur-émetteur est fonction de la différence entre les tensions appliquées à leurs bases. D'autre part, le potentiel de collecteur du transistor $T_2$ (ou $T_1$) varie peu étant donné qu'il est verrouillé à $V_3 - V_{BE}(T_6) - V_{BE}(T_4)$, $V_{BE}$ désignant la tension base-émetteur d'un transistor. La tension des collecteurs de $T_1$ et $T_2$ varie comme 2 fois la variation des tensions base-émetteur des transistors $T_3$ et $T_5$ d'une part et $T_4$ et $T_6$ d'autre part. En d'autres termes, le potentiel du collecteur des transistors $T_1$ et $T_2$ est pratiquement égal, à une constante donnée près, à la tension de référence. Comme en outre, le courant qui traverse le trajet collecteur-émetteur des transistors $T_1$ et $T_2$ est fixé par les sources de courant $I_3$ et $I_4$, la puissance dissipée dans les transistors $T_1$ et $T_2$, qui est proportionnelle au produit $V_{CE} * I_C$ est pratiquement constante ($I_C$ désignant le courant de collecteur et $V_{CE}$, la tension collecteur-émetteur d'un transistor).

Comme le potentiel du collecteur des transistors $T_1$ et $T_2$ varie peu, les sources de courant I3 et I4 peuvent être remplacées par des résistances de valeur élevée ( par exemple 1 MOhm ).

Toute variation du potentiel d'entrée du transistor $T_1$ ( ou $T_2$ ) tend à modifier la tension base-émetteur $V_{BE}$ de ce transistor. Cette modification du $V_{BE}$ induit une modification de son courant collecteur. Cette modification de courant se retrouve dans le courant de base du transistor $T_3$ ( ou $T_4$ ) puisque la charge du transistor $T_1$ ( ou $T_2$ ) présente un courant constant $I_3$ ( ou $I_4$ ). La variation du courant de base du transistor $T_3$ ( ou $T_4$ ) entraîne une variation de son courant collecteur qui par l'effet de la résistance d'émetteur du transistor $T_1$ ( ou $T_2$ ), conduit à reproduire les variations du potentiel d'entrée.

C'est ainsi que la tension émetteur du transistor $T_1$ ( ou $T_2$ ) est asservie à sa tension de base avec un décalage constant au premier ordre, puisque c'est le $V_{BE}$ correspondant au courant imposé par la source de courant $I_3$ ( ou $I_4$ ).

La distorsion thermique résulte des variations à court terme des températures de jonctions des transistors en fonction des signaux. Dans l'art antérieur, les dissipations modulées par l'amplitude des signaux font varier les caractéristiques des transistors, principalement la tension $V_{BE}$ et le gain en courant. Ainsi, dans le circuit différentiel classique, les variations thermiques de la tension base-émetteur $V_{BE}$ ont directement le même effet qu'une variation du signal d'entrée.

Dans le circuit de la figure 8, la dissipation du transistor $T_1$ ( ou $T_2$ ) est stabilisée. Elle n'entraîne donc pas de modulation de la tension $V_{BE}$. Le transistor $T_3$ ( ou $T_4$ ) travaille avec une tension émetteur-collecteur $V_{CE}$ faible, alors que le transistor $T_5$ ( ou $T_6$ ) voit des variations de courant et de tension émetteur-collecteur. Les tensions $V_{BE}$ des transistor $T_3$ ( ou $T_4$ ) et $T_5$ ( ou $T_6$ ) qui travaillent en courant dans la boucle, ont peu d'effet sur le montage, en raison de la faible variation de la tension émetteur-collecteur du transistor $T_1$ ( ou $T_2$ ). Les variations des gains en courant ( essentiellement pour le transistor $T_5$ ( ou $T_6$ ) utilisé en base commune ) ont peu d'effet sur le montage grâce à la boucle de contre-réaction en courant.

La valeur de la tension de référence $V_1$ est choisie de manière que la tension collecteur-base $V_{CB}$ des transistors $T_1$ et $T_2$ soit relativement peu élevée, à savoir inférieure à quelques Volts, de préférence inférieure à 1 Volt et typiquement de l'ordre de 200 à 300 millivolts.

EXEMPLE

$V_A$ = 15 Volts ; $V_1$ = 2 Volts
$I_{12}$ = 10 mA ; $I_3 = I_4$ = 2,5 mA
$R_{S1} = R_{S2}$ = 4 KOhm
$R_1 = R_2$ = 100 Ohm

La figure 9 montre un autre exemple dans lequel la linéarité a été obtenue par compensation des tensions $V_{BE}$ dans les deux branches du circuit différentiel. Deux transistors $T_9$ et $T_{10}$ de même type que les transistors T1 et T2 ont leur base et leur collecteur en connexion croisée. Le collecteur de $T_9$ et la base de $T_{10}$ sont connectés à l'émetteur de $T_1$. Les résistances $R_1$ et $R_2$ sont connectées en série sur les émetteurs de $T_9$ et $T_{10}$. La distorsion thermique est réduite grâce à la configuration cascode des transistors $T_5$ et $T_6$ qui impose une tension collecteur faible sur les transistors d'entrée et donc, limite la puissance dissipée dans ces transistors.

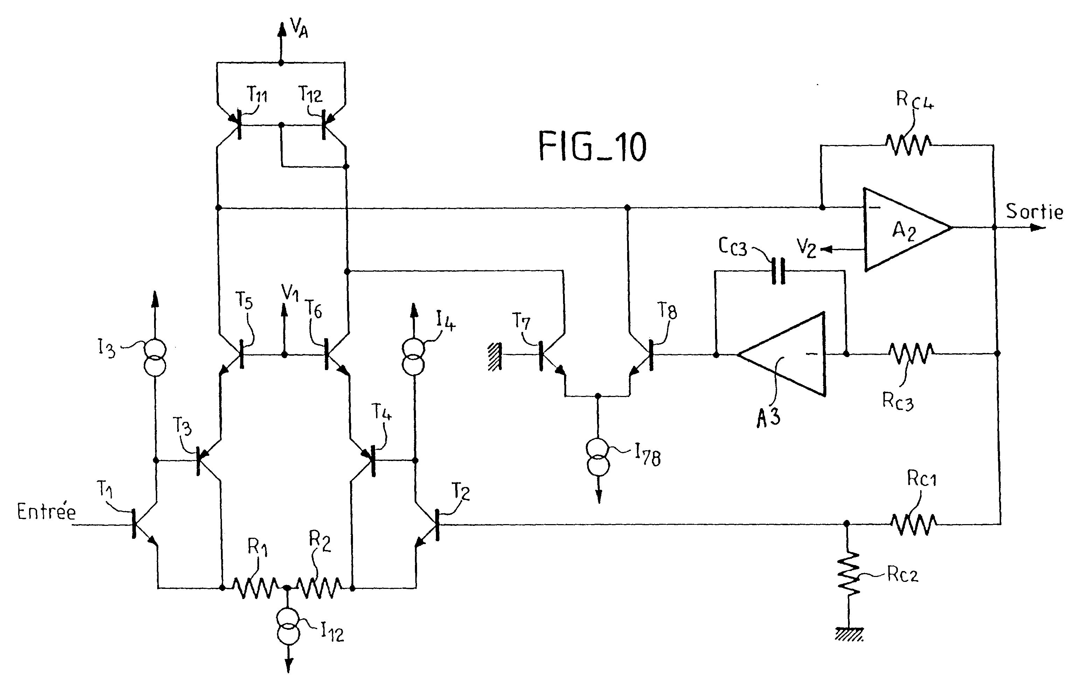

La figure 10 montre un mode de réalisation préféré de l'amplificateur selon la figure 4, qui est obtenu en utilisant dans le schéma de la figure 7, le circuit d'entrée décrit dans la figure 8. Un transistor $T_3$ a sa base connectée au collecteur de $T_1$, et son collecteur à l'émetteur de $T_1$. Un transistor $T_4$ a sa base connectée au collecteur de $T_2$, et son collecteur à l'émetteur de $T_2$. La charge du collecteur des transistors $T_1$ et $T_2$ est constituée par des sources de courant, respectivement $I_3$ et $I_4$. Deux transistors $T_5$ et $T_6$ de même type que les transistors $T_1$ et $T_2$ ont leur base portée à un potentiel de référence $V_1$ et leurs émetteurs connectés à ceux respectivement des transistors $T_3$ et $T_4$. Le collecteur du transistor $T_5$ est couplé aux collecteurs de $T_{11}$ et $T_8$ et à l'entrée inverseuse de $A_2$, le collecteur du transistor $T_6$ est couplé aux collecteurs de $T_{12}$ et $T_7$ et à la base de $T_{12}$.

A titre de variante de la figure 7, le premier étage peut présenter un étage d'entrée qui n'est pas du type différentiel, et le pont diviseur résistif ($R_{C1}$, $R_{C2}$) est disposé entre la sortie du deuxième étage ($A_2$) et une entrée du premier étage. La boucle de contre-réaction locale comporte un circuit intégrateur ($A_3$, $C_{C3}$) et un étage de contre-réaction qui est du type différentiel. L'entrée du circuit intégrateur est connectée à la sortie du deuxième étage ($A_2$) et sa sortie est connectée à une première entrée de l'étage différentiel de contre-réaction ($T_7$, $T_8$), lequel présente une deuxième entrée à potentiel constant $V_{p1}$. Une sortie de l'étage différentiel ($T_7$, $T_8$) est couplée à l'entrée de l'étage $A_2$, de manière à réaliser un filtre actif. Ce filtre actif permet d'éliminer d'une part les signaux continus ou basse fréquence issus du premier étage et d'autre part les signaux continus ou basse fréquence générés dans l'étage $A_2$, ce qui stabilise son point de fonctionnement.

## Revendications

1. Amplificateur à transistors pour signaux audio comportant un premier et un deuxième étage présentant une boucle de contre-réaction globale entre la sortie du deuxième étage qui constitue la sortie de l'amplificateur et l'entrée du premier étage, le deuxième étage présentant une boucle de contre-réaction locale entre sa sortie et son entrée et le premier étage ne comportant pas de contre-réaction locale entre sa sortie et son entrée et le premier étage ne comportant pas de contre-réaction locale entre sa sortie et son entrée, la boucle de contre-réaction globale et la boucle de contre-réaction locale présentant, respectivement, un premier et un deuxième éléments comparateurs, caractérisé en ce que l'amplificateur comporte un moyen permettant d'empêcher que la tension de décalage présente en sortie du premier étage ne soit réinjecté dans le premier comparateur d'entrée par contre-réaction et en ce que la boucle de contre-réaction locale est telle que le deuxième étage est contre-réactionné au moins en continu de telle sorte que les signaux perturbateurs basse fréquence générés dans le second étage soient réduits par la contre-réaction du second étage, ce qui stabilise son point de fonctionnement, de manière à stabiliser le point de polarisation du premier comparateur.

2. Amplificateur selon la revendication 1, caractérisé en ce que le premier étage présente une bande passante s'étendant jusqu'à zéro Hz.

3. Amplificateur selon une des revendications 1 ou 2, caractérisé en ce que le premier étage comporte un étage d'entrée, en ce que la boucle de contre-réaction globale présente un pont diviseur résistif ($R_{C1}$, $R_{C2}$) entre la sortie du deuxième étage et une entrée du premier étage et en ce que la boucle de contre-réaction locale comporte un circuit intégrateur ($A_3$, $C_{C1}$) et un étage différentiel de contre-réaction ($T_7$, $T_8$), l'entrée du circuit intégrateur étant connectée à la sortie du deuxième étage ($A_2$) et sa sortie étant connectée à une première entrée de l'étage différentiel de contre-réaction ($T_7$, $T_8$) lequel présente une deuxième entrée à potentiel constant, une sortie de l'étage différentiel de contre-réaction ($T_7$, $T_8$) étant couplée à une entrée respective du deuxième étage ($A_2$), de manière à réaliser un filtre actif qui élimine d'une part les signaux continus ou basse fréquence issus du premier étage et d'autre part, ceux générés dans le deuxième étage ($A_2$) ce qui stabilise son point de fonctionnement

4. Amplificateur selon une des revendications 1 à 3, caractérisé en ce que le premier et/ou le deuxième élément comparateur est tel qu'il présente au moins un transistor critique susceptible de produire des variations de sa fonction de transfert en fonction de l'amplitude des signaux et en ce que ledit transistor est agencé pour présenter une tension collecteur-émetteur $V_{CE}$ faible et/ou constante avec un courant sensiblement constant dans son trajet de courant principal de manière à produire une dissipation thermique stable et/ou faible dans ledit transistor critique.

5. Amplificateur selon la revendication 4, caractérisé en ce que lesdits transistors critiques à dissipation stable ou faible, et faisant partie d'un comparateur, sont isolés thermiquement des variations de température induites par d'autres composants, ou stabilisés thermiquement par une stabilisation qui leur est extérieure.

6. Amplificateur selon une des revendications 1 à 5, caractérisé en ce que ledit premier étage ($T_1$, $T_2$) utilise une charge active de manière à lui conférer un gain élevé et en ce que ledit deuxième étage ($A_2$) est contre-réactionné également pour les signaux dans la bande audio.

7. Etage amplificateur selon une des revendications précédentes, caractérisé en ce que le premier et/ou le deuxième étage utilise un comparateur de grande linéarité présentant deux sous-étages (($T_1$, $T_3$), ($T_2$, $T_4$)) en série pour former une contre-réaction locale.

8. Amplificateur selon une des revendications 1 à 6, caractérisé en ce que le premier et/ou le deuxième comparateur présente une combinaison d'éléments actifs ( $(T_1, T_{10})$, $(T_2, T_9)$ ) dont les non-linéarités intrinsèques se compensent.

9. Amplificateur selon la revendication 7, caractérisé en ce que le premier étage comprend deux modules dont chacun présente un premier transistor $(T_1)$ d'un premier type de conductivité dont la base constitue une borne d'entrée pour un signal d'entrée, les émetteurs du premier transistor $(T_1)$ de chaque module étant couplés à travers une impédance pour former un étage différentiel, et un moyen pour maintenir un courant sensiblement constant dans le trajet collecteur-émetteur du premier transistor $(T_1)$, ledit moyen comportant un circuit de contre-réaction (T3, $T_5$) présentant un trajet de courant principal entre une borne active $(S'_1)$ constituant une sortie du premier étage et l'émetteur du premier transistor $(T_1)$, en ce que ledit moyen est constitué par une première source de courant $(I_3)$ connectée au collecteur du premier transistor $(T_1)$ et en ce que le circuit de contre-réaction est agencé de manière telle que la valeur dudit courant principal est fonction de la différence entre la tension $(V_3)$ d'une source de tension de référence et le potentiel (VCT2) du collecteur du premier transistor $(T_1)$, le gain du circuit de contre-réaction étant choisi de manière telle que le potentiel du collecteur du premier transistor $(T_1)$ soit sensiblement constant

10. Amplificateur selon la revendication 9, caractérisé en ce que le trajet de courant principal du circuit de contre-réaction comporte un deuxième transistor $(T_3)$ d'un deuxième type de conductivité opposé au premier type de conductivité, dont le collecteur est connecté à l'émetteur du premier transistor $(T_1)$, dont la base est connectée au collecteur du premier transistor $(T_1)$, et dont l'émetteur est connecté à l'émetteur d'un troisième transistor $(T_5)$ d'un premier type de conductivité, dont la base est connectée à ladite source de tension de référence $(V_2)$, et dont le collecteur constitue ladite sortie du premier étage.

**Patentansprüche**

1. Transistorverstärker für Audiosignale mit einer ersten und einer zweiten Stufe, die eine Schleife mit globaler Rückkopplung zwischen dem Ausgang der zweiten Stufe, die den Ausgang des Verstärkers bildet, und dem Eingang der ersten Stufe bilden, wobei die zweite Stufe eine Schleife mit lokaler Rückkopplung zwischen ihrem Ausgang und ihrem Eingang bildet, wobei die erste Stufe keine lokale Rückkopplung zwischen ihrem Ausgang und ihrem Eingang aufweist, und wobei die Schleife mit globaler Rückkopplung und die Schleife mit lokaler Rückkopplung ein erstes und ein zweites Vergleichselement bilden, dadurch gekennzeichnet, daß der Verstärker ein Mittel aufweist, mit dem verhindert werden kann, daß der am Ausgang der ersten Stufe vorhandene Spannungsversatz durch Rückkopplung in den ersten Eingangskomparator erneut eingespeist wird, wobei die Schleife mit lokaler Rückkopplung so ist, daß die zweite Stufe zumindest für Gleichanteile so rückgekoppelt ist, daß die in der zweiten Stufe erzeugten Störsignale niedriger Frequenz durch die Rückkopplung der zweiten Stufe reduziert werden, wodurch deren Arbeitspunkt stabilisiert wird; so daß der Polarisationspunkt des ersten Komparators stabilisiert wird.

2. Verstärker nach Anspruch 1, dadurch gekennzeichnet, daß die erste Stufe einen Durchgangsbereich aufweist, der sich bis Null Hertz erstreckt.

3. Verstärker nach Anspruch 1 oder 2, dadurch gekennzeichnet, daß die erste Stufe eine Eingangsstufe aufweist, daß die Schleife mit globaler Rückkopplung eine Widerstandsteilerbrücke $(R_{C1}, R_{C2})$ zwischen dem Ausgang der zweiten Stufe und einem Eingang der ersten Stufe aufweist, und daß die Schleife mit lokaler Rückkopplung eine Integrationsschaltung $(A_3, C_{C1})$ und eine Rückkopplungs-Differentialstufe $(T_7, T_8)$ aufweist, wobei der Eingang der Integrationsschaltung an den Ausgang der zweiten Stufe $(A_2)$ angeschlossen ist und ihr Ausgang an einen ersten Eingang der Rückkopplungs-Differentialstufe $(T_7, T_8)$ angeschlossen ist, die einen zweiten Eingang mit konstantem Potential aufweist, wobei ein Ausgang der Rückkopplungs-Differentialstufe $(T_7, T_8)$ an einen Eingang der zweiten Stufe $(A_2)$ angeschlossen ist, so daß ein aktives Filter gebildet wird, das einerseits die Gleichsignale oder Signale mit niedriger Frequenz, die aus der ersten Stufe kommen, und andererseits die in der zweiten Stufe $(A_2)$ erzeugten Signale eliminiert, wodurch sein Arbeitspunkt stabilisiert wird.

4. Verstärker nach einem der Ansprüche 1 bis 3, dadurch gekennzeichnet, daß das erste und/oder das zweite Komparatorelement zumindest einen kritischen Transistor aufweist, der in der Lage ist, Veränderungen seiner Übertragungsfunktion in Abhängigkeit der Amplitude der Signale zu erzeugen, wobei dieser Transistor so eingerichtet ist, daß er eine geringe und/-oder konstante Kollektor-Emitterspannung $V_{CE}$ mit einem im wesentlichen konstanten Strom in seinem Hauptstrompfad aufweist, so daß eine stabile und/oder geringe thermische Dissipation in diesem kritischen Transistor auftritt.

5. Verstärker nach Anspruch 4, dadurch gekennzeichnet, daß die kritischen Transistoren mit stabiler oder geringer Dissipation, die einen Teil eines Komparators bilden, von den Temperaturveränderungen, die durch andere Bauteile eingebracht werden, thermisch isoliert sind, oder durch eine außerhalb von diesen befindliche Stabilisierung thermisch stabilisiert werden.

6. Verstärker nach einem der Ansprüche 1 bis 5, dadurch gekennzeichnet, daß die erste Stufe ($T_1$, $T_2$) eine aktive Last verwendet, so daß er einen großen Verstärkungsgrad erhält, wobei die zweite Stufe ($A_2$) auch für die Signale im Audiobereich rückgekoppelt ist.

7. Verstärkerstufe nach einem der vorangehenden Ansprüche, dadurch gekennzeichnet, daß die erste und/oder die zweite Stufe einen Komparator mit großer Linearität verwendet, der zwei in Reihe geschaltete Unterstufen (($T_1$, $T_3$), ($T_2$, $T_4$)) aufweist, um eine lokale Rückkopplung zu bilden.

8. Verstärker nach einem der Ansprüche 1 bis 6, dadurch gekennzeichnet, daß der erste und/oder der zweiten Komparator eine Kombination von aktiven Elementen (($T_1$, $T_{10}$), ($T_2$, $T_9$)) aufweist, deren eigene Nichtlinearitäten sich ausgleichen.

9. Verstärker nach Anspruch 7, dadurch gekennzeichnet, daß die erste Stufe zwei Module aufweist, von denen jedes einen ersten Transistor ($T_1$) eines ersten Leitfähigkeitstyps besitzt, dessen Basis einen Eingangsanschluß für ein Eingangssignal darstellt, wobei die Emitter des ersten Transistors ($T_1$) eines jeden Moduls über eine Impedanz gekoppelt sind, um eine Differentialstufe zu bilden, und ein Mittel zum Aufrechterhalten eines im wesentlichen konstanten Stroms im Kollektor-Emitterweg des ersten Transistors ($T_1$), wobei das Mittel eine rückgekoppelte Schaltung ($T_3$, $T_5$) aufweist, die einen Hauptstromweg zwischen einem aktiven Anschluß ($S'_1$), der einen Ausgang der ersten Stufe bildet, und dem Emitter des ersten Transistors ($T_1$) aufweist, wobei das genannte Mittel durch eine erste Stromquelle ($I_3$) gebildet wird, die mit dem Kollektor des ersten Transistors ($T_1$) verbunden ist, und wobei die rückgekoppelte Schaltung so eingerichtet ist, daß die Größe des genannten Hauptstroms eine Funktion der Differenz zwischen der Spannung ($V_3$) einer Bezugsspannungsquelle und dem Potential (VCT2) des Kollektors des ersten Transistors ($T_1$) ist, wobei der Verstärkungsfaktor der rückgekoppelten Schaltung so gewählt ist, daß das Potential des Kollektors des ersten Transistors ($T_1$) im wesentlichen konstant ist.

10. Verstärker nach Anspruch 9, dadurch gekennzeichnet, daß der Hauptstromweg der rückgekoppelten Schaltung einen zweiten Transistor ($T_3$) eines zweiten, dem ersten Leitfähigkeitstyp entgegengesetzten Leitfähigkeitstyps aufweist, dessen Kollektor mit dem Emitter des ersten Transistors ($T_1$) verbunden ist, dessen Basis mit dem Kollektor des ersten Transistors ($T_1$) verbunden ist und dessen Emitter mit dem Emitter eines dritten Transistors ($T_5$) eines ersten Leitfähigkeitstyps verbunden ist, dessen Basis mit der genannten Bezugsspannungsquelle ($V_2$) verbunden ist und dessen Kollektor den genannten Ausgang der ersten Stufe bildet.

## Claims

1. Amplifier having transistors for audio signals comprising a first and a second stage having a global feedback loop between the output of the second stage which constitutes the output of the amplifier and the input of the first stage, the second stage having a local feedback loop between its output and its input, and the first stage comprising no local feedback between its output and its input, the global feedback loop and the local feedback loop having respectively a first and a second comparator element, characterised in that the amplifier comprises a means making it possible to prevent the offset voltage present at the output of the first stage from being reinjected into the first input comparator owing to feedback and in that the local feedback loop is such that the second stage receives feedback at least continuously so that the low frequency interference signals generated in the second stage are reduced by the feedback of the second stage, which stabilises its operational point so as to stabilise the polarisation point of the first comparator.

2. Amplifier according to claim 1, characterised in that the first stage has a pass band extending to zero Hz.

3. Amplifier according to one of claims 1 or 2, characterised in that the first stage comprises an input stage, in that the global feedback loop has a resistive divider bridge ($R_{C1}$, $R_{C2}$) between the output of the second stage and an input of the first stage and in that the local feedback loop comprises an integrating circuit ($A_3$, $C_{C1}$) and a differential

feedback stage ($T_7$, $T_8$), the input of the integrating circuit being connected to the output of the second stage ($A_2$) and its output being connected to a first input of the differential feedback stage ($T_7$, $T_8$) which has a second input with a constant potential, an output of the differential feedback stage ($T_7$, $T_8$) being coupled to a respective input of the second stage ($A_2$) so as to produce an active filter which eliminates on the one hand the continuous or low frequency signals issued from the first stage and on the other hand those generated in the second stage ($A_2$), which stabilises its operational point.

4. Amplifier according to one of claims 1 to 3, characterised in that the first and/or second comparator element is such that it has at least one critical transistor able to produce variations in its transfer operation depending on the amplitude of the signals, and in that the said transistor is arranged to present a low and/or constant collector-emitter voltage $V_{CE}$ with a substantially constant current in its main current path so as to produce a stable and/or low thermal dissipation in the said critical transistor.

5. Amplifier according to claim 4, characterised in that the said critical transistors with stable or low dissipation and forming part of a comparator are thermally insulated from variations in temperature induced by other components or are thermally stabilised by a stabilisation external thereto.

6. Amplifier according to one of claims 1 to 5, characterised in that the said first stage ($T_1$, $T_2$) uses an active charge so as to endow it with a high gain, and in that the said second stage ($A_2$) receives feedback also for the signals in the audio band.

7. Amplifier stage according to one of the preceding claims, characterised in that the first and/or second stage uses a high linearity comparator having two sub-stages ( ($T_1$, $T_3$), ($T_2$, $T_4$) ) in series to form a local feedback.

8. Amplifier according to one of claims 1 to 6, characterised in that the first and/or second comparator has a combination of active elements ( ($T_1$, $T_{10}$), ($T_2$, $T_9$) ) of which the intrinsic non-linearities compensate for each other.

9. Amplifier according to claim 7, characterised in that the first stage comprises two modules of which each has a first transistor ($T_1$) of a first conductivity type of which the base constitutes an input terminal for an input signal, the emitters of the first transistor ($T_1$) of each module being coupled across an impedance in order to form a differential stage, and a means for maintaining a substantially constant current in the collector-emitter path of the first transistor ($T_1$), the said means comprising a feedback circuit ($T_3$, $T_5$) having a main current path between an active terminal ($S'_1$) constituting an output of the first stage and the emitter of the first transistor ($T_1$), in that the said means is comprised of a first current source ($I_3$) connected to the collector of the first transistor ($T_1$) and in that the feedback circuit is arranged so that the value of the said main current is dependent on the difference between the voltage ($V_3$) of a source of reference voltage and the potential (VCT2) of the collector of the first transistor ($T_1$), the gain of the feedback circuit being selected so that the potential of the collector of the first transistor ($T_1$) is substantially constant.

10. Amplifier according to claim 9, characterised in that the main current path of the feedback circuit comprises a second transistor ($T_3$) of a second conductivity type opposite to the first conductivity type, of which the collector is connected to the emitter of the first transistor ($T_1$), of which the base is connected to the collector of the first transistor ($T_1$) and of which the emitter is connected to the emitter of the third transistor ($T_5$) of a first conductivity type, of which the base is connected to the said source of reference voltage ($V_2$) and of which the collector constitutes the said output of the first stage.

# FIG_1

# FIG_2

## FIG_3

## FIG_5

## FIG_4

18

FIG_6

FIG_7

# FIG_8

# FIG_9

FIG_10